# EUROPEAN PATENT APPLICATION

(11) **EP 4 664 521 A1**
(43) Date of publication of application: **17.12.2025**
(21) Application number: 25178515.0
(22) Date of filing: 23.05.2025
(51) Int. Cl.: H01L 23/373, H01L 23/42

(54) **COOLING APPARATUS AND METHOD OF MANUFACTURING A COOLING APPARATUS**

(30) Priority: 14.06.2024 US 202418743736
(71) Applicant: Google LLC, Mountain View, CA 94043 (US)
(72) Inventor: AHMAD, Mudasir, Mountain View, CA 94043 (US); BOND, David Matthew, Mountain View, CA 94043 (US); CHEN, Huijuan, Mountain View, CA 94043 (US); PARIKH, Niyati, Mountain View, CA 94043 (US); UDHAYAKUMAR, Sudharshan Sugavanesh, Mountain View, CA 94043 (US)
(74) Representative: Betten & Resch

(57) **Abstract**

A cooling apparatus for a chip package includes a cooling device, a thermal interface material, and a thermal enclosure. The thermal interface material is layered between the cooling device and the chip. The thermal enclosure is fixed between the cooling device and the chip surrounding the thermal interface material. The thermal enclosure is configured to provide an outlet for the thermal interface material therethrough. A method of manufacturing such a cooling apparatus is also provided.

## Description

### BACKGROUND

Rapid growth in chip complexity has resulted in an exponential increase in chip usage in high-speed applications. High-speed applications result in higher power densities which cause an increase in the heat generated by the chips. Currently, liquid cooling systems are effective to cool the chips but the cost of implementing such liquid cooling systems is high, especially as the heat generated by the chips increases.

### BRIEF SUMMARY

Aspects of this disclosure are directed to a cooling apparatus for a chip package and a method of manufacturing such a cooling apparatus. A cooling apparatus includes a cooling device, a thermal interface material layered between the cooling device and a chip, and a thermal enclosure that surrounds the thermal interface material and provides an outlet for the thermal interface material to flow through.

One aspect of the disclosure is directed to a cooling apparatus for a chip package including a cooling device, a thermal interface material layered between the cooling device and a chip, and a thermal enclosure fixed between the cooling device and the chip surrounding the thermal interface material. The thermal enclosure is configured to provide an outlet for the thermal interface material therethrough. The cooling device may be a cold plate or a heatsink.

In some arrangements, the thermal enclosure may comprise a divider configured to provide a first and a second section within the thermal enclosure.

In some arrangements, the thermal enclosure may comprise a porous material including a plurality of pores configured to allow air to flow out of the thermal interface material.

In some arrangements, the thermal enclosure may comprise a porous material including a plurality of pores configured to allow the thermal interface material to flow through the plurality of pores.

In some arrangements, the thermal enclosure may have an opening configured to allow the thermal interface material to flow through the opening.

In some arrangements, the thermal enclosure may comprise a compressible thermal conductive material.

In some arrangements, the thermal enclosure may comprise a silicone gel or a polymer matrix.

In some arrangements, the thermal enclosure may comprise a material having an adhesive surface.

Another aspect of the disclosure is directed to a cooling apparatus for a chip package comprising a cooling device, a thermal interface material layer between the cooling device and a chip, and a thermal enclosure fixed between the cooling device and the chip surrounding the thermal interface material. The thermal enclosure includes a divider configured to provide a first and a second section within the thermal enclosure.

In some arrangements, the first section may include a first thermal interface material and the second section includes a second thermal interface material.

In some arrangements, the thermal enclosure may include one or more divider configured to provide a plurality of sections within the thermal enclosure.

Yet another aspect of the disclosure is directed to a cooling apparatus for a chip package comprising a cooling device, a thermal interface material layered on an upper surface of a chip, and a thermal enclosure fixed between the cooling device and the upper surface of the chip. The thermal enclosure includes a cavity and the cavity is configured to accommodate the thermal interface material.

In some arrangements, the layered thermal interface material may have a height less than a height of the cavity of the thermal enclosure extending from the inner surface of the cavity to the upper surface of the chip.

In some arrangements, the thermal enclosure may comprise a porous material including a plurality of pores configured to allow air to flow out of the thermal interface material.

In some arrangements, the thermal enclosure may comprise a porous material including a plurality of pores configured to allow the thermal interface material to flow through the plurality of pores.

In some arrangements, the thermal enclosure may comprise an opening in a wall of the cavity configured to allow the thermal interface material to flow through the opening.

In some arrangements, the thermal enclosure may comprise a compressible thermal conductive material.

In some arrangements, the thermal enclosure may comprise a silicone gel or a polymer matrix.

In some arrangements, the thermal enclosure may comprise a material having an adhesive surface.

In some arrangements, the cooling device may be configured to compress the thermal enclosure reducing a height extending from a bottom surface of the thermal enclosure to a top surface of the thermal enclosure.

Yet another aspect of the disclosure is directed method of manufacturing a cooling apparatus comprising applying a thermal interface material layer on a predetermined area on a first side of a cooling device; attaching a thermal enclosure on the first side of the cooling device surrounding the predetermined area; flipping the cooling device; and installing the cooling device onto a chip, wherein the first side of the cooling device having the thermal interface material faces a top surface of the chip, thereby sandwiching the thermal interface material and the thermal enclosure between the cooling device and the chip.

In some arrangements, applying the thermal interface material on the cooling device may further comprise placing a stencil on the first side of the cooling device, the stencil having an opening defining the predetermined area; applying the thermal interface material on the first side of the cooling device within the opening of the stencil; and removing the stencil from the first side of the cooling device.

In some arrangements, installing the cooling device onto the chip may further comprise securing the thermal enclosure and thermal interface material to the cooling device with a cover.

### BRIEF DESCRIPTION OF THE DRAWINGS

In the drawings, which are presented in simplified form and are not drawn to precise scale:
Fig. 1 is a cross-sectional view of a cooling apparatus assembly on a chip package according to aspects of the disclosure.
Fig. 2A is a schematic diagram illustrating the cooling apparatus of Fig. 1 at room temperature according to aspects of the disclosure.
Fig. 2B is a schematic diagram illustrating the cooling apparatus of Fig. 1 at a higher temperature according to aspects of the disclosure.
Fig. 3 is a top view of a first example of a thermal enclosure of a cooling apparatus according to aspects of the disclosure.
Fig. 4 is a top view of a second example of a thermal enclosure of a cooling apparatus according to aspects of the disclosure.
Fig. 5 is a cross-sectional view of a third example of a thermal enclosure of a cooling apparatus according to aspects of the disclosure.
Fig. 6 is a top view of a fourth example of a thermal enclosure of a cooling apparatus according to aspects of the disclosure.
Fig. 7 is a flowchart of a method of manufacturing the cooling apparatus of Fig. 1 according to aspects of the disclosure.
Figs. 8A-8D illustrate various stages of the method of manufacturing the cooling apparatus according to aspects of the disclosure.

### DETAILED DESCRIPTION

### Overview

Aspects of the disclosure relate to a cooling apparatus assembly on a chip package and a method of manufacturing such a cooling apparatus. The cooling apparatus may include a cooling device, a Thermal Interface Material ("TIM") layer, and a thermal enclosure or dam surrounding the TIM layer. The cooling device may include a cold plate or an air-cooling heat sink. The cooling device may be secured via a spring assembly to contact a silicon chip in the chip package. The TIM layer is disposed between the chip and the cooling device. The thermal enclosure may be made out of a compressible material and is positioned between the cooling device and the chip. The thermal enclosure may provide multiple advantages including mitigating excess TIM overflow, reducing the thermal resistance of the TIM, absorbing tolerance variations in the cooling apparatus, and promoting heat transfer from the chip to the cooling device as well as absorbing heat from the chip itself.

TIMs are commonly used in chip packages to ensure consistent and reliable heat transfer from the chip to the cooling device. In particular, the TIM is a thermally conductive material used to promote heat transfer between the chip and the cooling device. Grease based TIMs such as silicone gels and TIMs made from phase change materials are often used as they are versatile and do not require burn-in or elevated temperature component testing prior to use. Further, grease based TIMs are easily dispensable and can be reworked at various locations such as a factory or a datacenter.

Current cooling apparatuses using TIMs pose a number of challenges in high heat fluctuation applications. The repeated heating and cooling cycles of the chip causes warpage of the chip. Grease based TIMs are not able to compress to accommodate the pressure from the chip warpage. The chip warpage may push the TIM out of the interface, also known as "pumpout." Thus, the pumpout induced by the warpage of the chip results in a reduction of the TIM between the chip and the cooling device, adversely affecting the heat transfer therebetween. Lastly, the cooling device spring assembly may also create pressure variations throughout the entire chip package.

### Cooling Apparatus

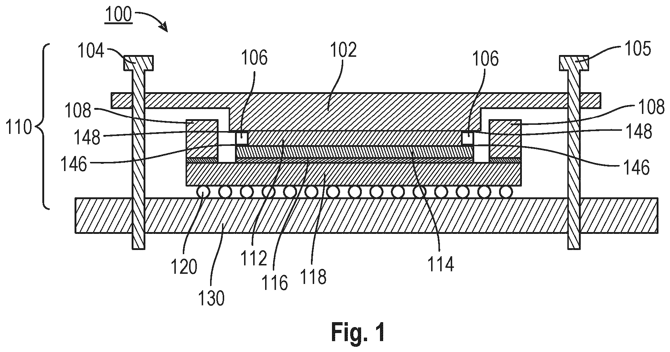

Fig. 1 is a cross-sectional view of a cooling apparatus assembly 100 on a chip package 110 according to aspects of the disclosure. As shown in Fig. 1, a chip package 110 may be arranged on a printed circuit board 130. A substrate 118 of the chip package 110 is connected to the printed circuit board 130 by a ball grid array 120, for example. An underfill layer 116 is disposed on top of the substrate 118. A silicon die or chip 114 is positioned on top of the underfill 116 layer. A TIM layer 112 is applied to the top surface of the chip 114. A thermal enclosure 106 is positioned around the TIM layer 112. The cold plate 102 may include a spring assembly having springs 104, 105 holding the cold plate 102 above the chip 114 at a predetermined pressure. In some examples, the spring assembly may include one or more springs. In other examples, instead of a cold plate, an air-cooled heat sink may be positioned above the chip 114. The substrate 118 may include a stiffener ring 108 positioned along a perimeter of a top surface of the substrate. The springs 104, 105 and the stiffener ring 108 are configured so that the cold plate 102 may only be pressed to a distance allowed by the stiffener ring. When the tolerances of the system are well-controlled, the stiffener ring 108 may act as a stop for the cold plate 102.

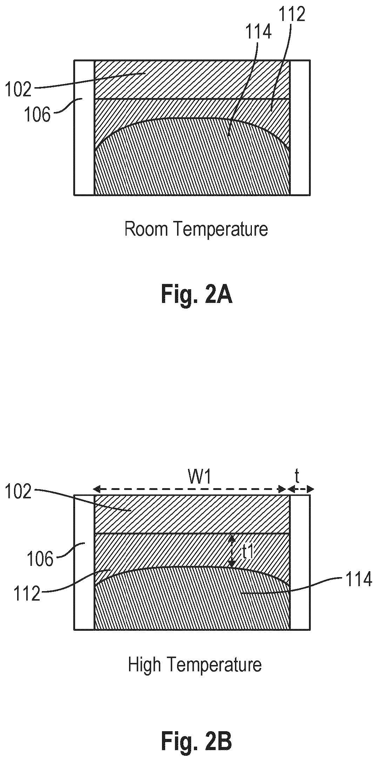

Additionally, as shown in Fig. 1, the TIM layer 112 is disposed between the cold plate 102 and the chip 114. The thermal enclosure 106 is disposed between the cold plate 102 and the chip 114 to surround the TIM layer 112. The thermal enclosure 106 provides an outlet for the TIM layer 112 to flow through. The thermal enclosure 106 may minimize the TIM layer 112 overflow as the chip 114 undergoes heating and cooling cycles. Figs. 2A and 2B are schematic diagrams illustrating the cooling apparatus 100 of Fig. 1 at room temperature and at a higher temperature according to aspects of the disclosure. As the chip 114 moves from a higher temperature to room temperature and vice versa, the chip 114 warps into a curved surface that pushes upward into the cold plate 102. At room temperature the chip 114 may be curved into a convex shape and at higher temperatures the chip may be less curved than at room temperature, flat, or curved into a concave shape.

The thermal enclosure 106 may be thicker than the TIM layer 112. For example, the thickness t₁ of the TIM layer 112 may be less than thickness t of the thermal enclosure 106. The TIM layer 112 may have a width W1. Thus, the repetitive pressure created from chip warpage during heating and cooling of the chip package on the TIM layer 112 is spread over the surface area of the thermal enclosure 106. Additionally, the thickness t of the thermal enclosure 106 can be designed to survive a number of repeated heating and cooling cycles based on the individual chip application. The thickness t of the thermal enclosure 106 may also be designed to accommodate various internal pressures transmitted by the TIM layer 112 from the chip warpage. The thickness t may vary on the selected material for the TIM layer 112. Some enclosure materials could handle higher thresholds and others could handle lower ones. The thermal enclosure 106 may have a high life expectancy if the strain in the thermal enclosure wall remains below a critical threshold. The critical threshold of strain in the thermal enclosure 106 is determined by a target bond line thickness of the TIM layer 112 between the chip 114 and the cold plate 102, an initial thickness of the material, and the target lifetime of the thermal enclosure. In some cases, the critical threshold may be a strain less than 30%. In some examples, the critical threshold may be a strain of 30% or greater. In other examples, the critical threshold may be a strain ranging from 50% to 70%.

The TIM may include a silicone based thermal grease, a TIM grease, a polymer matrix with conductive particles, a silicone gel, an adhesive, or a liquid such as a liquid metal. In one example, the TIM layer 112 may include more than one layer of the TIM. In another example, the TIM layer 112 may include a first layer of a first TIM and a second layer of a second TIM. In some examples, a first TIM having a lower coefficient of thermal expansion may be used closer to the chip 114 to reduce stress and a second TIM having a higher coefficient of thermal expansion may be layered on top of the first TIM closer to the cold plate 102. The thermal enclosure 106 may include a thermal conductive material different from that of the TIM layer 112. In some examples, the thermal enclosure 106 may include one or more layers, each layer including a different TIM. In some examples, the thermal enclosure 106 may be made of a compressible TIM such as a silicon gasket material that compresses under the pressure of the springs 104, 105. In some examples, the thermal enclosure 106 may include one or more adhesive layers, for example, a first adhesive layer 146 between the thermal enclosure and the chip 114 and/or a second adhesive layer 148 between the thermal enclosure and the cold plate 102. The adhesive layers 146, 148 will hold the thermal enclosure 106 in a fixed position between the chip 114 and the cold plate 102. In other examples, the thermal enclosure 106 may be made of a material having an adhesive surface or adhesive properties, which allow the thermal enclosure to remain fixed in place which can be useful during manufacturing assembly and installation. The thermal enclosure 106 may be made from a compressible material and may absorb manufacturing tolerance variations of the chip and/or the cooling apparatus to promote stability and reduce unit to unit variation.

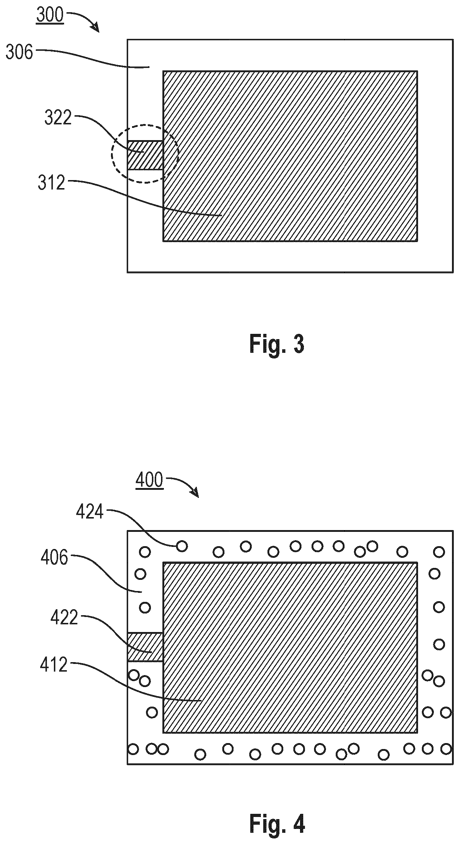

Fig. 3 is a top view of a first example of a thermal enclosure 306 of a cooling apparatus 300 according to aspects of the disclosure. As shown in Fig. 3, in some examples, the thermal enclosure 306 may include an opening 322 for an overflow of the TIM layer 312 to flow through. In some examples, the opening 322 may be a rectangular cross-section, however the cross-section of the opening is not limited as such. The size and width of the opening 322 may vary depending on how much TIM layer 312 overflow needs to be released in a particular application. In some examples, the thermal enclosure 306 may include one or more openings.

Fig. 4 is a top view of a second example of a thermal enclosure 406 of a cooling apparatus 400 according to aspects of the disclosure. As shown in Fig. 4, in some examples, the thermal enclosure 406 may include a porous material having a plurality of pores 424. The plurality of pores 424 may allow air to flow out of the TIM layer 412 and reduce pressure buildup during the heating and cooling cycles. In some examples, the porous material may be selected to only allow air bubbles to flow out and to restrain the TIM layer 412 within the thermal enclosure 406. In some examples, the TIM layer 412 may also flow through one or more of the plurality of pores 424. In other examples, the thermal enclosure 406 may include a porous material and an opening 422 to allow the overflow of the TIM layer 412 to flow.

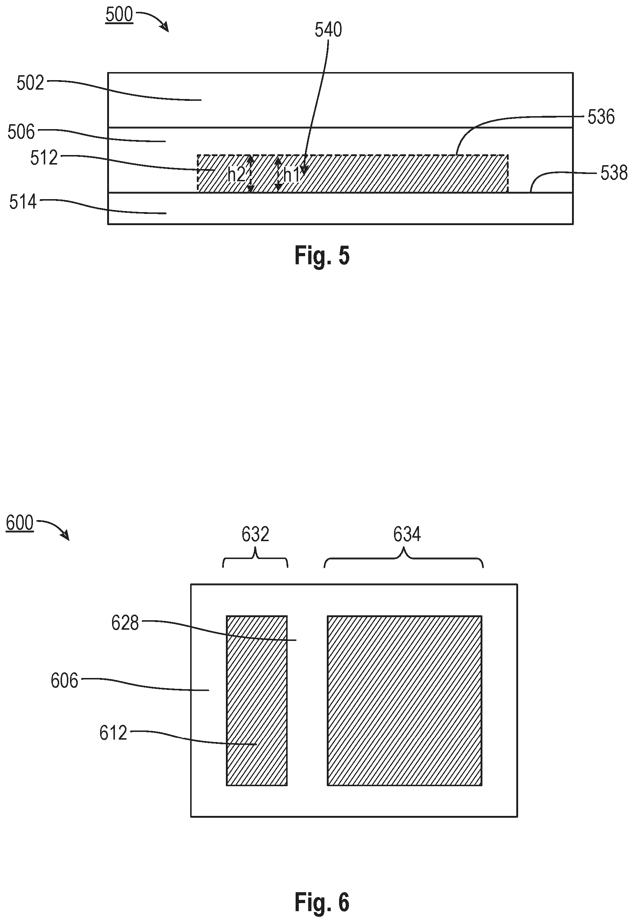

Fig. 5 is a cross-sectional view of a third example of a thermal enclosure 506 of a cooling apparatus 500 according to aspects of the disclosure. As shown in Fig. 5, in some examples, the TIM layer 512 may be disposed on an upper surface 538 of a chip 514. The thermal enclosure 506 may be fixed between the cold plate 502 and the upper surface 538 of the chip 514. The thermal enclosure 506 may include a cavity 540 configured to accommodate the TIM layer 512. In some examples, the cavity 540 may be located at the center of the thermal enclosure 506. An inner surface 536 of the cavity 540 may rest above the TIM layer 512. The TIM layer 512 may have a height h₁ less than a height h₂ of the cavity 540 of the thermal enclosure 506. In an example, the TIM layer 512 may have a height h₁, whereas the cavity 540 may have a height h₂.The height h₂ of the cavity 540 extends from the inner surface 536 of the cavity 540 to the upper surface 538 of the chip 514. In some examples, the thermal enclosure 506 may also include one or more openings, a porous material, or a combination of both.

The cold plate 102 may compress the thermal enclosure 506 uniformly or non-uniformly to reduce the height h₂ of the thermal enclosure, i.e., the height extending from a bottom surface of the thermal enclosure to a top surface of the thermal enclosure. Since the TIM layer 512 may have a height h₁ lower than the height h₂ of the central cavity of the thermal enclosure, the TIM layer can spread out as the thermal enclosure is compressed. The thermal enclosure 506 is compressed to a target bond line thickness of the TIM layer 512. Reducing the bond line thickness of the thermal enclosure 506 reduces the thermal resistance of the thermal enclosure material, and in turn, increases the thermal conductivity of the thermal enclosure.

Fig. 6 is a top view of a fourth example of a thermal enclosure 606 of a cooling apparatus 600 according to aspects of the disclosure. As shown in Fig. 6, in some examples, the thermal enclosure 606 may include a divider 628 configured to provide a first section 632 and a second section 634 within the thermal enclosure 606. The TIM layer 612 may be encompassed within both the first section 632 and the second section 634. In other examples, the thermal enclosure 606 may include one or more dividers providing a plurality of sections within the thermal enclosure. The plurality of sections may isolate areas of the chip from each other which reduces cross-heating across the chip. In some examples, each section of the thermal enclosure 606 may include an opening. In other examples, the thermal enclosure 606 may include one or more openings, a porous material, or a combination of both. In some examples, the first section 632 may include a first TIM and the second section 634 may include a second TIM depending on the heat generated by various areas of the chip. Some portions of the chip may require less or more heat dissipation. As such, one or more dividers provide the flexibility to align various portions of the chip with different TIM materials having varying heat dissipation properties.

The cooling apparatus may be used for TPUS, CPUS, and other chips having high density applications.

### Method of Manufacture

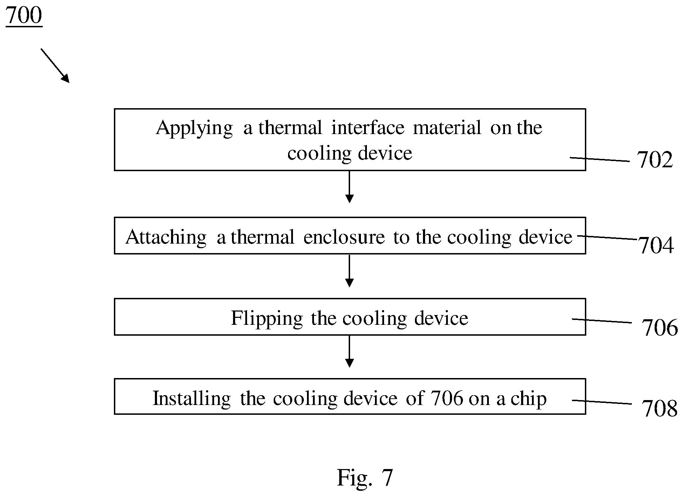

Aspects of this disclosure relate to a method of manufacturing a cooling apparatus. Fig. 7 is a flowchart of a method 700 of manufacturing the cooling apparatus of Fig. 1 according to aspects of the disclosure. A method 700 of manufacturing a cooling apparatus includes applying a TIM layer on the cooling device 702, attaching a thermal enclosure to the cooling device 704, flipping the cooling device 706, and installing the cooling device on a chip 708. In some examples, as shown in the figures, cooling device may include a cold plate, however, method 700 is not limited as such.

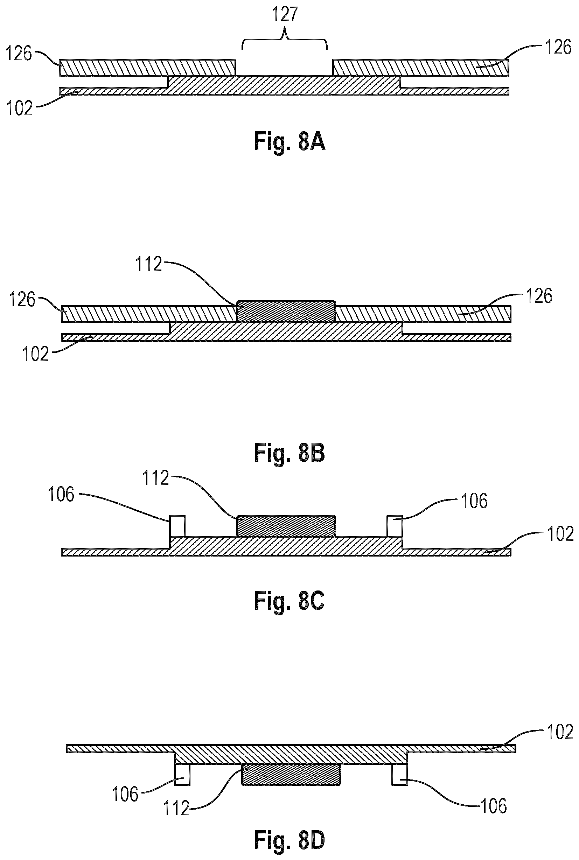

In block 702, the TIM layer is applied on a predetermined area on a first side of a cold plate. In some examples, the TIM may be applied directly on the chip. In some examples, as shown in Figs. 8A-8B, applying the TIM layer 112 on the cold plate 102 may include placing a stencil 126 on the first side of the cold plate. The stencil 126 may have an opening 127 that defines the predetermined area for the TIM layer 112. In some examples, the stencil may be a unitary piece, in other examples, the stencil may include multiple pieces. After placing the stencil, the TIM layer is applied on the first side of the cold plate within the opening of the stencil. After the TIM layer is applied, the stencil is removed from the cold plate.

In block 704, the thermal enclosure is attached on the first side of the cold plate surrounding the predetermined area. As shown in Fig. 8C, the thermal enclosure 106 is placed on the cold plate 102 around the TIM layer 112.

In block 706, after the thermal enclosure is attached, the cold plate is flipped. In some examples, the thermal enclosure may have adhesive properties allowing the thermal enclosure to stick into place on the upper side of the cold plate. In other examples, the thermal enclosure is held in place during flipping and installation onto a chip. As shown in Fig. 8D, the thermal enclosure 106 and TIM layer 112 may both be applied to the cold plate 102 prior to flipping the cold plate.

In block 708, after the cold plate is flipped, the cold plate is installed onto a chip. The first side of the cold plate having the TIM layer faces a top surface of the chip. Thus, the TIM layer and the thermal enclosure are sandwiched between the cold plate and the chip.

In some examples, the thermal enclosure may be pre-assembled on the cold plate during the cold plate manufacture. The thermal enclosure and the TIM layer are secured to a cold plate with a cover and shipped to a manufacturing facility to be installed on a chip. In other examples, the cold plate and the thermal enclosure may be shipped separately to a manufacturing facility or a datacenter. The thermal enclosure is installed when the cold plate is installed on the chip. In some examples, the TIM layer may be applied to the cold plate before installation. In other examples, the TIM layer and the thermal enclosure may be applied directly to the chip surface before installation at the manufacturing facility or datacenter. After the TIM layer and the thermal enclosure are applied to the chip, the cold plate is attached to the thermal enclosure.

Although the implementations disclosed herein have been described with reference to particular features, it is to be understood that these features are merely illustrative of the principles and applications of the present implementations. It is therefore to be understood that numerous modifications, including changes in the sizes of the various features described herein, may be made to the illustrative implementations and that other arrangements may be devised without departing from the spirit and scope of the present implementations. In this regard, the present implementations encompass numerous additional features in addition to those specific features set forth in the paragraphs above.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description should be taken by way of illustration rather than by way of limitation of the subject matter defined by the claims. In addition, the provision of the examples described herein, as well as clauses phrased as "such as," "including" and the like, should not be interpreted as limiting the subject matter of the claims to the specific examples; rather, the examples are intended to illustrate only one of many examples. Further, the same reference numbers in different drawings can identify the same or similar elements.

## Claims

1. A cooling apparatus for a chip package, comprising:
a cooling device;
a thermal interface material layered between the cooling device and a chip; and
a thermal enclosure fixed between the cooling device and the chip surrounding the thermal interface material, the thermal enclosure configured to provide an outlet for the thermal interface material therethrough.

2. The cooling apparatus of claim **1,** wherein the cooling device is a cold plate or a heatsink.

3. The cooling apparatus of claim 1 or claim 2, wherein the thermal enclosure comprises a divider configured to provide a first and a second section within the thermal enclosure.

4. The cooling apparatus of any one of claims 1 to 3, wherein the thermal enclosure comprises a porous material including a plurality of pores configured to allow air to flow out of the thermal interface material; and/or
wherein the thermal enclosure comprises a porous material including a plurality of pores configured to allow the thermal interface material to flow through the plurality of pores.

5. The cooling apparatus of any one of claims 1 to 4, wherein the thermal enclosure has an opening configured to allow the thermal interface material to flow through the opening; and/or
wherein the thermal enclosure comprises a compressible thermal conductive material; and/or
wherein the thermal enclosure comprises a silicone gel or a polymer matrix; and/or
wherein the thermal enclosure comprises a material having an adhesive surface.

6. A cooling apparatus for a chip package, comprising:
a cooling device;
a thermal interface material layer between the cooling device and a chip; and
a thermal enclosure fixed between the cooling device and the chip surrounding the thermal interface material, the thermal enclosure including a divider configured to provide a first and a second section within the thermal enclosure.

7. The cooling apparatus of claim 6, wherein the first section includes a first thermal interface material and the second section includes a second thermal interface material; and/or
wherein the thermal enclosure includes one or more divider configured to provide a plurality of sections within the thermal enclosure.

8. A cooling apparatus for a chip package, comprising:
a cooling device;
a thermal interface material layered on an upper surface of a chip; and
a thermal enclosure fixed between the cooling device and the upper surface of the chip, the thermal enclosure including a cavity;
wherein the cavity is configured to accommodate the thermal interface material.

9. The cooling apparatus of claim 8, wherein the layered thermal interface material has a height less than a height of the cavity of the thermal enclosure extending from the inner surface of the cavity to the upper surface of the chip.

10. The cooling apparatus of claim 8 or claim 9, wherein the thermal enclosure comprises a porous material including a plurality of pores configured to allow air to flow out of the thermal interface material; or
wherein the thermal enclosure comprises a porous material including a plurality of pores configured to allow the thermal interface material to flow through the plurality of pores; and/or
wherein the thermal enclosure comprises an opening in a wall of the cavity configured to allow the thermal interface material to flow through the opening.

11. The cooling apparatus of any one of claims 8 to 10, wherein the thermal enclosure comprises a compressible thermal conductive material; and/or
wherein the thermal enclosure comprises a silicone gel or a polymer matrix; and/or
wherein the thermal enclosure comprises a material having an adhesive surface.

12. The cooling apparatus of any one of claims 8 to 11, wherein the cooling device is configured to compress the thermal enclosure reducing a height extending from a bottom surface of the thermal enclosure to a top surface of the thermal enclosure.

13. A method of manufacturing a cooling apparatus, comprising:
applying a thermal interface material layer on a predetermined area on a first side of a cooling device;
attaching a thermal enclosure on the first side of the cooling device surrounding the predetermined area;
flipping the cooling device; and
installing the cooling device onto a chip, wherein the first side of the cooling device having the thermal interface material faces a top surface of the chip, thereby sandwiching the thermal interface material and the thermal enclosure between the cooling device and the chip.

14. The method of claim 13, wherein applying the thermal interface material on the cooling device further comprises:
placing a stencil on the first side of the cooling device, the stencil having an opening defining the predetermined area;
applying the thermal interface material on the first side of the cooling device within the opening of the stencil; and
removing the stencil from the first side of the cooling device.

15. The method of claim 13 or claim 14, wherein installing the cooling device onto the chip further comprises securing the thermal enclosure and thermal interface material to the cooling device with a cover.
